(19) **Europäisches Patentamt**
**European Patent Office**
**Office européen des brevets**

(11) **EP 2 099 964 B1**

(12) **EUROPÄISCHE PATENTSCHRIFT**

(45) Veröffentlichungstag und Bekanntmachung des Hinweises auf die Patenterteilung:
**14.02.2018 Patentblatt 2018/07**

(21) Anmeldenummer: **07816247.6**

(22) Anmeldetag: **13.11.2007**

(51) Int Cl.:
**D02G 3/44** *(2006.01)* **C23C 14/56** *(2006.01)*
**C23C 14/14** *(2006.01)*

(86) Internationale Anmeldenummer:
**PCT/CH2007/000564**

(87) Internationale Veröffentlichungsnummer:
**WO 2008/058412 (22.05.2008 Gazette 2008/21)**

(54) **BESCHICHTETER FADENFÖRMIGER GEGENSTAND MIT VERBESSERTER ELEKTRISCHER LEITFÄHIGKEIT UND/ODER VERBESSERTER OPTISCHER REFLEXION UND VORRICHTUNG UND VERFAHREN ZUM BEHANDELN DER OBERFLÄCHE EINES FADENFÖRMIGEN GEGENSTANDES**

COATED THREADLIKE OBJECT WITH IMPROVED ELECTRICAL CONDUCTANCE AND/OR IMPROVED OPTICAL REFLECTION AND DEVICE FOR TREATING THE SURFACE OF A THREADLIKE OBJECT

OBJET FILIFORME ENROBÉ À CONDUCTIVITÉ ÉLECTRIQUE AMÉLIORÉE ET/OU À RÉFLEXION OPTIQUE AMÉLIORÉE, ET DISPOSITIF ET PROCÉDÉ DE TRAITEMENT DE SURFACE D'UN OBJET FILIFORME

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **13.11.2006 CH 18192006**

(43) Veröffentlichungstag der Anmeldung:
**16.09.2009 Patentblatt 2009/38**

(73) Patentinhaber: **Serge Ferrari Tersuisse AG**
**6021 Emmenbrücke (CH)**

(72) Erfinder:
• **HEUBERGER, Manfred**
**9030 Abtwil (CH)**
• **KELLER, Michael**
**7310 Bad Ragaz (CH)**

• **AMBERG, Martin**
**9403 Goldach (CH)**
• **HEGEMANN, Dirk**
**9014 St. Gallen (CH)**

(74) Vertreter: **Kleinschmidt, Michael et al**
**Schmauder & Partner AG**
**Patent- und Markenanwälte VSP**
**Zwängiweg 7**
**8038 Zürich (CH)**

(56) Entgegenhaltungen:
**EP-A- 0 574 020 EP-A- 0 731 206**
**WO-A-92/14860 DE-A1- 19 612 225**
**DE-U1- 29 600 991 JP-A- 8 158 269**
**JP-A- 2000 314 039 US-A- 3 379 803**
**US-A- 5 413 851**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Technisches Gebiet

Die Erfindung betrifft einen beschichteten fadenförmigen Gegenstand mit verbesserter elektrischer Leitfähigkeit und/oder verbesserter optischer Reflexion. Weiterhin betrifft die Erfindung eine Vorrichtung und ein Verfahren zum Behandeln der Oberfläche eines fadenförmigen Gegenstandes, um einen solchen beschichteten fadenförmigen Gegenstand mit verbesserter elektrischer Leitfähigkeit und/oder verbesserter optischer Reflexion zu erhalten.

Stand der Technik

Um metallisierte Fäden für entsprechend hochwertig veredelte Textilien zu verwenden, ist es von grossem Interesse, dass die metallisierten Fäden dieselben textilen Eigenschaften wie unbeschichtete Fäden aufweisen. Andernfalls müssen besondere Vorkehrungen beim Verarbeiten wie Weben, Wirken, Stricken oder Sticken getroffen werden, und es treten vermehrt Schlaufenbildungen im Gebrauch durch Relativbewegungen der Fäden auf. Für typische Anwendungen wie textile Leiter oder Elektroden ist dabei eine gute Leitfähigkeit gefordert. Für dekorative Zwecke ist weiterhin ein metallisches Erscheinungsbild, d.h. eine gute Reflexion, erforderlich. Deshalb ist die Anforderung gute metallische Schichten, d.h. elektrisch leitfähige oder reflektierende Schichten, mit geringer Menge an aufgetragenem Metall auf dem Faden zu erzeugen.

Das derzeit gebräuchlichste Verfahren zur Metallisierung von Fasern beruht auf einem autokatalytischen, stromlosen Verfahren (US-A-4 042 737). Die Metallisierung auf den Fäden kann weiterhin galvanisch verstärkt werden. Die Haftung der Schichten beruht auf mechanischer Verankerung durch Anätzen (Aufrauhen) der Fäden vor der Beschichtung. Verfahrensbedingt tritt Inselwachstum mit vielen Korngrenzen auf. Daher sind grössere Mengen an aufgetragenem Metall erforderlich, um geschlossene Schichten mit guten elektrischen Eigenschaften zu erzielen. Weiterhin sind die Schichten gräulich und wenig reflektierend. Daher ergeben viele Studien mit metallisierten Fäden bisher unbefriedigende Ergebnisse, entsprechend veröffentlicht z.B. "Smart textiles for medicine and healthcare", ed. L. Van Langenhove, Woodhead, Cambridge, 2007.

Prinzipiell könnten auch andere Verfahren wie thermische Verfahren durch Verdampfen zur Metallisierung verwendet werden wie im der DD-252 009 A1 dargestellt. Es ist aber von der Beschichtung auf flachen Substraten bekannt, dass diese im Vergleich zur Sputterbeschichtung schlechtere Eigenschaften aufweisen, vor allem geringere Schichthomogenität und Haftung, so dass diese für die Beschichtung von Fäden keine Anwendung finden. Von daher sind insbesondere Sputterverfahren, die auf dem Abtrag eines Targetmaterials z.B. durch Erzeugung eines Niederdruckplasmas beruhen von Interesse. Das Patent EP 0 695 384 B1 erwähnt bereits die prinzipielle Eignung dieses Verfahrens. Ebenfalls haben eigene Arbeiten die Metallisierung von Fäden durch Besputtern zum Gegenstand, veröffentlicht von M. Amberg, J. Geerck, M. Keller, A. Fischer in Plasma Devices and Operations 12, 175-186, 2004. Allerdings ist für die kontinuierliche Metallisierung von Fäden ein geeigneter Transport durch Vakuumkammern mit entsprechend angeordneter Plasmaquelle erforderlich, wofür noch keine Lösung bekannt ist, die grosse Prozessgeschwindigkeit, die in textilen Prozessen üblich sind, mit homogenen Metallisierungen kombiniert. Sputterverfahren finden daher noch keine Anwendung für die Metallisierung von Fäden. Patentdokumente, die den Transport von Fäden zur Beschichtung beschreiben verwenden jeweils Führungselemente wie einzelne Rollen, Rillen etc. (DD 252 009 A1, JP 2005-113 165 A, US-A-5 972 160, WO-A-92/014 860, WO-A-97/036 021, DE 41 05 896 A1) oder eine Verschiebung der Transportrollen in einer einzigen Ebene, so dass die Anzahl der umlaufenden Fäden durch unterschiedlichen Abstand begrenzt ist (US-A-3 379 803). In der DE 196 12 225 A1 wird ein Faden einfach durch eine Beschichtungskammer geführt, wobei allerdings keine Massnahmen zur radial gleichmässigen Beschichtung vorgeschlagen werden. In der JP 2000-314039 A1 wird eine gleichmässige Beschichtung vorgeschlagen.

Darstellung der Erfindung

Aufgabe der Erfindung ist es, eine Vorrichtung zu schaffen und ein Verfahren vorzuschlagen, mit der eine Behandlung, nämlich eine Plasmabeschichtung von fadenförmigen Gegenständen, insbesondere von Fäden, im kontinuierlichen Verfahren durchgeführt werden kann, wobei eine gleichmässige Behandlung bzw. Beschichtung von allen Seiten der Fäden und ein optimaler Ablauf Voraussetzung ist und damit die Möglichkeit zu schaffen, die fadenförmigen Gegenstände mit einer wesentlich verbesserten Beschichtung eine verbesserte elektrische Leitfähigkeit und/oder eine verbesserte optische Reflexion herzustellen.

Die Aufgabe der Erfindung wird durch eine Vorrichtung nach Anspruch 1 gelöst. Die vorliegende Erfindung löst die erwähnten Beschränkungen durch die Anordnung einer Sputterquelle vor einer Fadenwand, die durch den Transport des Fadens über zwei verschränkte zylinderförmige Rollen (Walzen) ermöglicht wird, die den Umlauf eng nebeneinander liegender Fadenabschnitte ermöglicht. Durch die Verschränkung der Rollen oder Walzen, d.h. der Verschiebung der Rollenachsen gegeneinander in zwei Winkeln in zwei verschiedenen Richtungen bleibt der Fadenabstand von Umschlingung zu Umschlingung annähernd unverändert, es tritt keine Dehnung der Fäden beim Umlauf um die zwei Rollen auf. Insbesondere wird der Faden durch die doppelte Verschränkung der Rollen und die mehrfache Umschlingung um die Rollen beim Transport in sich gedreht.

Daher können mehrere hundert Fadenumläufe um die beiden Rollen bei hohen Geschwindigkeiten realisiert werden, und der Faden wird infolge der Drehung von allen Seiten homogen metallisiert. Es sind dabei keine Führungselemente wie z.B. Rillen notwendig. Diese sogenannten Galetten finden bereits in textilen Prozessen wie der Verstreckung beim Spinnprozess Anwendung (z.B. WO-A-93/08320), ohne dass es dabei auf enge Fadenführung oder eine zusätzliche Veredlung ankäme. Durch die geschickte Kombination von Fadentransport, Anordnung der Sputterquellen und allseitige Beschichtung werden metallisierte Fäden homogen mit guten elektrischen und reflektierenden Eigenschaften erzeugt, die zudem eine geringere Menge an aufgetragenem Metall als die bekannten Verfahren erfordern. Überraschenderweise hat sich gezeigt, dass es vor allem bei Garnen beim Umlauf zu einem Aufspreizen der einzelnen Filamente kommt, wodurch die Metallisierung sehr effektiv durchgeführt wird. Eigene Arbeiten mit Sputterquellen zur Metallisierung haben gezeigt, dass erst durch die beschriebene Erfindung metallisierte Fäden mit guten elektrischen und reflektierenden Eigenschaften erzeugt werden konnten. Dabei haben die Massnahmen der Erfindung zur Folge, dass eine qualitativ hochwertige Behandlung eines Fadens oder eines fadenartigen Gegenstandes einfach durchgeführt werden kann. Durch die Anordnung der Rollen ist es möglich, quasi eine Fläche mit nebeneinander angeordneten Fäden zwischen den Rollen auszubilden, die so dicht sein kann, dass eine optimale Ausnutzung der Behandlungseinrichtung möglich ist. Die Behandlung umfasst eine Plasmabeschichtung mit einer Plasmabeschichtungsquelle. Für bestimmte Anwendungen kann es vorteilhaft sein, wenn die Vorrichtung zusätzlich zur Plasmabeschichtungsquelle eine Elektrode zum Abscheiden insbesondere aus der Gasphase auf dem fadenförmigen Gegenstand aufweist (Anspruch 2), wobei der Abstand zwischen Elektrode und dem fadenförmigen Gegenstand kleiner ist als 2 cm oder zwischen der Elektrode und dem fadenförmigen Gegenstand ein Kontakt besteht. Um - wie vorstehend schon beschrieben - vermeiden zu können, dass die Rollen ausschliesslich durch den Zug des Fadens angetrieben werden, wird gemäss Anspruch 3 eine Antriebseinrichtung für die Rollen, insbesondere ein Motor für jede der Rollen, vorgesehen sein. Wenn die Vorrichtung zwei, im Wesentlichen parallele Plasmabeschichtungseinrichtungen aufweist, wird jeweils eine der Plasmabeschichtungseinrichtungen einer Oberfläche des fadenförmigen Gegenstandes zwischen den Rollen zugeordnet sein (Anspruch 4). Zur vorstehend beschriebenen verbesserten Beschichtung kann die Vorrichtung Mittel zum Einrichten eines elektrischen Spannungspotentials oder einer Wechselspannung zwischen einer der Rollen oder den Rollen und der Beschichtungskammer aufweisen (Anspruch 5). Zur Qualitätserhöhung der Beschichtung können Elektrodenmittel vorgesehen sein, die zwischen den Rollen ein elektrisches Spannungspotential mittels einer Gleich- oder Wechselspannung für die zusätzliche Elektrode erzeugen. Vorteilhaft ist es, wenn die Rollen zum Ausgleich der Wärmeentwicklung durch die Beschichtung mit Plasma gekühlt werden können. Insbesondere für das Anfahren der Anlage kann aber auch ein Heizen der Rollen erforderlich sein. Es kann auch eine Plasmareinigungseinrichtung zum Reinigen des fadenförmigen Gegenstandes vor dem Zuführen in die Beschichtungskammer vorgesehen sein. Ein entsprechendes Verfahren, das die Aufgabe der Erfindung gemäss diesem Aspekt löst, ist in Anspruch 7 angegeben. Für bestimmte Anwendung kann es dabei vorteilhaft sein, gemäss der vorliegenden Erfindung (Anspruch 8), wenn auf dem fadenförmigen Gegenstand zusätzlich zur Plasmabeschichtung mittels einer Elektrode aus einer Gasphase eine Abscheidung erfolgt. Grundsätzlich ist vorgesehen, dass der Faden oder fadenförmige Gegenstand um zwei Rollen O-förmig geführt ist. Für bestimmte Anwendungen kann es aber vorteilhaft sein, wenn der Faden oder fadenförmige Gegenstand in Form einer Acht um die Rollen geführt wird, wobei die Rollen dabei gegenförmig gedreht werden. Für bestimmte Anwendungen ist es vorteilhaft, wenn zwischen einer der zwei Rollen oder den Rollen und der Beschichtungskammer ein elektrisches Spannungspotential oder eine Wechselspannung eingerichtet wird (Anspruch 9). Um eine Erwärmung auszugleichen, werden die Rollen beim Betrieb vorteilhafterweise gekühlt. Es kann aber auch möglich sein, dass die Rollen beim Betrieb geheizt werden sollten. Für bestimmte Anwendungen kann das Verfahren und das damit hergestellte Produkt noch verbessert werden durch ein zusätzliches Tauchbeschichten nach dem Plasmabeschichten. Insbesondere, wenn ein elektrisch leitender Faden hergestellt werden soll, kann es vorteilhaft sein, wenn der elektrische Widerstand des fadenförmigen Gegenstandes während des Beschichtungsprozesses gemessen wird. Damit kann dann der Prozess mit dem Messwert des elektrischen Widerstandes gesteuert oder geregelt werden (Ansprüche 10).

Der behandelte fadenförmige Gegenstand weist durch die sehr dünne Schicht, durch die die textilen Eigenschaften erhalten bleiben, erhebliche Vorteile auf. Er kann anhand aller gängigen Weiterverarbeitungstechniken, wie Weben, Wirken und Sticken weiterverarbeitet werden. Dies hat neben einer Einsparung an Materialressourcen auch bessere Waschbeständigkeit zur Folge.

Unter einem fadenförmigen Gegenstand wird in diesem Patent ein dünner, langer, biegsamer Gegenstand verstanden, der von einem Wickel abgespult, textil - z.B. in Web- oder Wirkmaschinen - verarbeitet und wie in der Erfindung beschrieben über die gegeneinander verschobenen Transportrollen mit vielen Umwindungen transportiert werden kann, so dass fortlaufende Teilabschnitte des fadenförmigen Gegenstands jeweils nebeneinander mittels einer Beschichtungseinrichtung beschichtet werden können und der fadenförmige Gegenstand anschliessend wieder auf einen zweiten Wickel aufgespult werden kann. Insbesondere werden unter fadenförmigen Gegenständen Fäden, die aus einem oder mehreren Filamenten aufgebaut sind und/oder Fasern für textile Gebilde verstanden (Garn, Zwirn etc.).

Die vorbenannten sowie die beanspruchten und in den nachfolgenden Ausführungsbeispielen beschriebenen, erfindungsgemäss zu verwendenden Elemente unterliegen in ihrer Grösse, Formgestaltung, Materialverwendung und ihrer technischen Konzeption keinen besonderen Ausnahmebedingungen, so dass die in dem jeweiligen Anwendungsgebiet bekannten Auswahlkriterien uneingeschränkt Anwendung finden können.

Kurze Beschreibung der Zeichnungen

Weitere Einzelheiten, Vorteile und Merkmale des Gegenstandes der vorliegenden Erfindung ergeben sich aus der nachfolgenden Beschreibung der dazu gehörenden Zeichnungen, in denen das erfindungsgemässe Verfahren und entsprechende Vorrichtungen beispielhaft erläutert werden. In den Zeichnungen zeigt:

Figur 1    eine Vorrichtung gemäss einer bevorzugten Ausführung der vorliegenden Erfindung in einer Ansicht in der Achse der Rollen, mit einer O-förmigen Fadenanordnung und zwei Plasmabeschichtungseinrichtungen;

Figur 2    die Vorrichtung gemäss der Ausführung gemäss Figur 1 in einer Ansicht in der Achse der Rollen, hier mit der O-förmigen Fadenanordnung und einer Plasmabeschichtungseinrichtung;

Figur 3    eine Darstellung einer Beschichtungskammer gemäss der bevorzugten Ausführung der vorliegenden Erfindung mit einer Darstellung der Fadenführung;

Figur 4    ein Diagramm der elektrischen Leitfähigkeit von metallisierten Fäden gemäss der vorliegenden Erfindung im Vergleich zu vorbekannten metallisierten Fäden.

Wege zur Ausführung der Erfindung

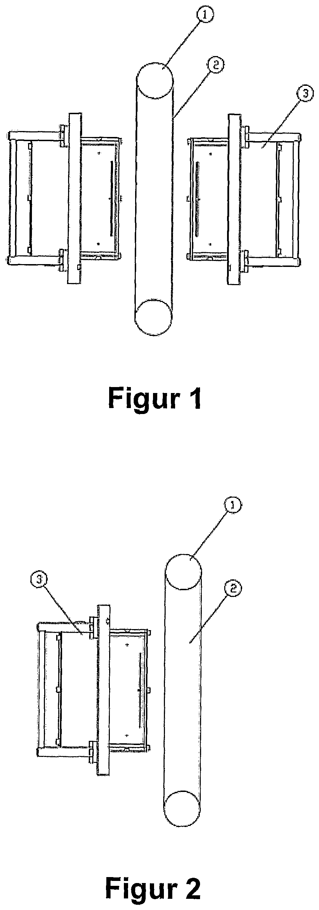

In dem in Figur 1 gezeigten Ausführungsbeispiel umfasst die Vorrichtung zum Plasmabeschichten von fadenförmigen Gegenständen 2 angetriebene Rollen 1 die im Vakuum einer als Beschichtungskammer ausgebildete Behandlungskammer betrieben werden. Die fadenförmigen Gegenstände 2 können dabei insbesondere Fäden sein, die aus einem oder mehreren Filamenten aufgebaut sind und/oder Fasern für textile Gebilde umfassen (Garn, Zwirn etc.). Grundsätzlich nicht ausgeschlossen sind schmale Bänder, Schläuche etc., die mittels der Vorrichtung bzw. des Verfahrens der Erfindung transportiert und beschichtet sowie textil verarbeitet werden können. In dieser Ausführung sind zwei als Plasmaquelle ausgebildete Beschichtungseinrichtungen 3 vorgesehen, die den Faden 2 dementsprechend von je einer Seite her beschichten. In dem hier dargestellten Ausführungsbeispiel sind beide Rollen 1 direkt von einem Motor 4 angetrieben. In dieser Ausführung ist der Faden 2 O-förmig über die Rollen verlegt und bildet quasi eine ebene Fadenwand.

In diesem Ausführungsbeispiel weisen die Rollen zueinander einen ersten Winkel von 2,5° auf, um den die obere Rolle - in der Figur 1 - in ihrem hinteren Teil nach oben gekippt ist. Zum Ausgleich der durch diesen Kippwinkel verursachten Längenunterschiede der Teilabschnitte des fadenförmigen Gegenstandes sind die Rollen um einen zweiten Winkel von ebenfalls ca. 2,5° windschief zueinander angeordnet, die obere Rolle ist also - in der Figur 1 - vorne nach rechts gegenüber der unteren Rolle gekippt.

In dieser Ausführung sind zwei als Plasmaquelle ausgebildete Beschichtungseinrichtungen 3 vorgesehen, die eine sehr hohe Beschichtungsgeschwindigkeit und damit eine kleine Durchlaufzeit des Fadens 2 durch die Beschichtungskammer 9 erlauben. Die Rollen 1 sind zylindrisch ohne Konizität gebaut. Das Garn ist nur so lange elektrisch statisch, bis es erstmals durch die Beschichtung leitfähig gemacht wird. Ein Kleben ist nicht zu erwarten. Die Sputterquelle wird im Ausführungsbeispiel nicht vollständig auf die Fadenwand ausgerichtet. Es treffen folglich Partikel auf die Rollen 1. Eine gelegentliche Reinigung der Rollen 1 ist daher notwendig. Deshalb wird ein Wechseln der Rollen 1 vorgesehen, das möglichst einfach sein soll.

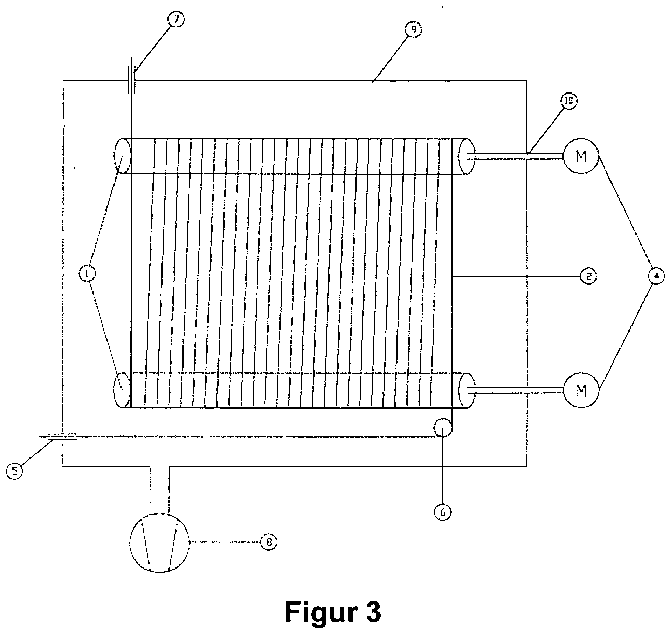

Im Folgenden wird an Hand von Figur 3 ein typischer Verfahrensablauf zum Beschichten eines fadenförmigen Gegenstandes, der nachfolgend verkürzt als Faden 2 bezeichnet wird, beschrieben:

Der Faden wird durch den Fadeneinlass 5 der Beschichtungskammer zugeführt und dann über eine Umlenkrolle 6 über die Rollen 1 transportiert, so dass eine Fadenwand ausgebildet wird, auf die die gesputterten Partikel geschossen werden. Nach dem Beschichten wird der Faden durch den Auslass 7 abgeführt. In der Beschichtungskammer wird mit der Vakuumpumpe 8 die für die Plasmabeschichtung notwendige Umwelt erzeugt. Um die Rollen 1 mittels der ausserhalb der Beschichtungskammer 9 angeordneten Motoren 4 antreiben zu können, sind in der seitlichen Wand der Beschichtungskammer 9 Drehdurchführungen 10 vorgesehen. Die gesputterten, Teilchen der als Magnetronplasmaquelle ausgebildeten Beschichtungseinheit 3 kondensieren auf dem Faden 2. Dabei wird die Energie der vom Faden 2 abgebremsten Partikel in Wärme umgewandelt. Diese Wärme erhitzt den Faden 2. Damit gleich bleibende Eigenschaften des Prozesses und des Fadens erhalten bleiben, wird im hier beschriebenen Ausführungsbeispiel der Faden 2 gekühlt. Die Kühlung erfolgt über Strahlung vom wasserdurchströmten Kühlkörper innerhalb der Rollen 1.

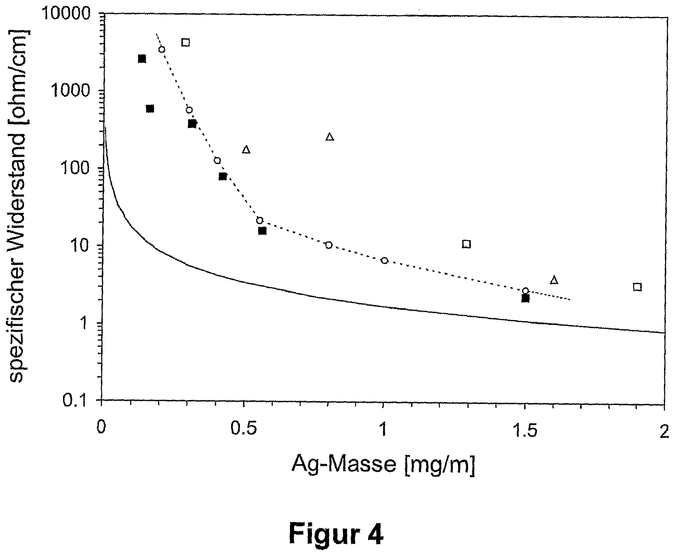

Der Effekt der Erfindung in Bezug auf den elektrischen Widerstand von metallisierten Fäden ist in Figur 4 dargestellt. Es handelt sich dabei um multifilamente Fasern, die mittels des erfinderischen Verfahrens in einer Vorrichtung gemäss der vorliegenden Erfindung hergestellt wurden, bei denen die Metallschicht - im vorliegenden Ausführungsbeispiel eine Silberschicht - also mittels einer Plasmabeschichtungseinrichtung auf die vorstehend beschriebene Fadenwand aufgebracht wurde. Als durchgezogene Linie ist dabei die theoretische Grenze des spezifischen Widerstandes in Ohm/cm angegeben, der sich aus einer vollkommen homogenen Silberschicht ergeben würde. Die gefüllt eingezeichneten rechteckigen Punkte geben Messwerte des gemessenen Widerstandes eines Fadens gemäss der vorliegenden Erfindung an, während die ungefüllten rechteckigen Punkte die Messwerte eines vorbekannten Fadens und die ungefüllten dreieckigen Punkte die Messwerte eines weiteren vorbekannten Fadens (Shieldex® Faden) gemäss dem Stand der Technik wiedergeben. Shieldex® ist der Markenname von elektrochemisch versilberten - monofilen und multifilen - Nylon-Fäden, die von der Firma Statex angeboten werden. Die ungefüllten runden Punkte sind die Werte zu der Wertetabelle des spezifischen elektrischen Widerstandes der Metallschicht von dem

2,5 fachen bei einer Aufbringungsmenge von 1,5 mg/m, normiert auf die Dichte von Ag,

4 fachen bei einer Aufbringungsmenge von 1,0 mg/m, normiert auf die Dichte von Ag,

5 fachen bei einer Aufbringungsmenge von 0,8 mg/m, normiert auf die Dichte von Ag,

7 fachen bei einer Aufbringungsmenge von 0,55 mg/m, normiert auf die Dichte von Ag,

30 fachen bei einer Aufbringungsmenge von 0,4 mg/m, normiert auf die Dichte von Ag,

100 fachen bei einer Aufbringungsmenge von 0,3 mg/m, normiert auf die Dichte von Ag,

400 fachen bei einer Aufbringungsmenge von 0,2 mg/m, normiert auf die Dichte von Ag,

des theoretischen spezifischen elektrischen Widerstandes. Diese Punkte sind in Figur 4 mit einer gestrichelten Linie miteinander verbunden.

Um dem Fachmann eine Methode zur Ermittlung des elektrischen Widerstandes an die Hand zu geben, wird diese im Folgenden kurz - beispielhaft - beschrieben:

Der elektrische Widerstand des metallisierten Garns kann nach der Messmethode der Zweileiter-Widerstandsmessung über zwei Kupferrollen mit einem Durchmesser von 10 mm und einer Distanz von 2 cm gemessen werden.

Das metallisierte Garn wird dabei zur Kontaktierung über die angetriebenen, mit der Fadengeschwindigkeit laufenden Kupferrollen (Ablenkung min. 45° je Kupferrolle) geführt. Der Widerstand wird dabei arithmetisch über mehrere Meter gemittelt.

Der ermittelte spezifische elektrische Widerstand wird in Ohm/cm angegeben. Dazu wird der gemessene Widerstandswert durch die Messlänge dividiert.

Der theoretische spezifische elektrische Widerstand (Widerstand pro Fadenlänge) R/l ergibt sich aus der Annahme einer defektfreien, gleich verteilten Metallschicht um den fadenförmigen Gegenstand und wird aus der Masse der Metallschicht pro Fadenlänge m/l (in g/cm) berechnet gemäss

$$R/l = \rho_{el}\, \rho\, (m/l)^{-1},$$

wobei $\rho_{el}$ (in ohm cm) der spezifische elektrische Widerstand des Metalls und $\rho$ (in g/cm$^3$) die Dichte des Metalls bezeichnet.

Bei dem Effekt der Erfindung in Bezug auf die optische Reflexion von metallisierten Fäden handelt es sich dabei ebenfalls um die multifilamenten Fasern.

Die Werte der Reflexion der Metallschicht im nahen Infrarot gemessen an parallel liegenden Fäden von

30% bei einer Aufbringungsmenge von 0,5 mg/m, normiert auf die Dichte von Ag,

40% bei einer Aufbringungsmenge von 1,0 mg/m, normiert auf die Dichte von Ag,

50% bei einer Aufbringungsmenge von 1,5 mg/m, normiert auf die Dichte von Ag,

der theoretischen optischen Reflexion der entsprechenden glatten Metalloberfläche werden mit den Massnahmen der Erfindung erreicht.

Ermittlung der optischen Reflexion:

Die optische Reflexion wurde nach CIE No. 38 Kapitel 12.2.2 (1977) "Strahlungsphysikalische und Lichttechnische Stoffkennzahlen und deren Messung" durchgeführt. Das Garn wurde auf einen schwarzen Probenträger parallel gewickelt, sodass der Untergrund keine optische Beeinflussung ausübt.

An einer Probe der Abmessung 15x25 mm wurden die direkte und die diffuse Reflexion mit gerichtetem Lichteinfall (8°/diffus) mit einer Ulbrichtschen Kugel im Bereich von 750 nm - 2000 nm (nahes Infrarot) gemessen.

Bezugszeichenliste

1  Rollen
2  Faden, Faser, fadenförmiger Gegenstand
3  Beschichtungseinheit
4  Motoren

5    Fadeneinlass in die Kammer
6    Umlenkrolle
7    Fadenauslass aus der Kammer
8    Vakuumpumpe
9    Beschichtungskammer
10   Drehdurchführung

**Patentansprüche**

1. Vorrichtung zum Behandeln der Oberfläche eines fadenförmigen Gegenstandes (2), insbesondere der Oberfläche von Fäden, die aus einem oder mehreren Filamenten aufgebaut sind und/oder von Fasern für textile Gebilde, mit
einer Behandlungskammer (9) mit zumindest einer Oberflächenbehandlungseinrichtung (3) zur Behandlung der Oberfläche des fadenförmigen Gegenstandes (2),
einer Einrichtung zum Transport (4, 6) des fadenförmigen Gegenstandes (2) durch die Behandlungskammer (9),
einer in der Behandlungskammer (9) befindlichen Rolleneinrichtung (1, 10) mit zwei Rollen (1) zum Aufspannen und fortlaufendem Transportieren von Teilabschnitten des fadenförmigen Gegenstandes (2) jeweils nebeneinander,
einer Einrichtung (7) zum Herausführen des fadenförmigen Gegenstandes aus der Behandlungskammer (9),
**dadurch gekennzeichnet, dass**
die Rollen (1) zueinander einen ersten, Längenunterschiede der Teilabschnitte verursachenden Verschränkungswinkel von 0,5° bis 10°, vorzugsweise von 2° bis 3°, aufweisen und
die Rollen zum Ausgleich der durch den besagten ersten Verschränkungswinkel verursachten Längenunterschiede der Teilabschnitte des fadenförmigen Gegenstandes (2) um einen zweiten Verschränkungswinkel windschief zueinander angeordnet sind, wobei die Oberflächenbehandlungseinrichtung (3) eine Plasmabeschichtungseinrichtung, mit einem Sputtertarget zum Aufbringen einer Schicht mit einer Schichtdicke von unter 1000 nm, insbesondere mit einer elektrisch leitenden Schicht, umfasst.

2. Vorrichtung nach Anspruch 1, weiterhin **gekennzeichnet durch** eine Elektrode insbesondere zum Abscheiden aus der Gasphase auf dem fadenförmigen Gegenstand, wobei zwischen der Elektrode und dem fadenförmigen Gegenstand ein Kontakt besteht oder der Abstand zwischen Elektrode und dem fadenförmigen Gegenstand (2) kleiner ist als 2 cm.

3. Vorrichtung nach einem der Ansprüche 1 oder 2, **gekennzeichnet durch** zumindest eine Antriebseinrichtung (4) für die Rollen, vorzugsweise einen Motor für jede der Rollen, zum Zwecke des Transports und der Führung des fadenförmigen Gegenstandes (2).

4. Vorrichtung nach einem der Ansprüche 1 bis 3, **dadurch gekennzeichnet, dass** sie eine weitere Plasmabeschichtungseinrichtung, zur ersten Plasmabeschichtungseinrichtung (3) im Wesentlichen parallele Plasmabeschichtungseinrichtung aufweist, wobei die beiden Plasmabeschichtungseinrichtungen jeweils einem zugewandten Bereich der Oberfläche des fadenförmigen Gegenstandes (2) zwischen den Rollen (1) zugeordnet sind.

5. Vorrichtung nach einem der Ansprüche 1 bis 4, **gekennzeichnet durch** Mittel zum Einrichten eines elektrischen Spannungspotentials oder einer Wechselspannung zwischen einer Rolle der zwei Rollen (1) oder den Rollen (1) und der Behandlungskammer (9).

6. Vorrichtung nach einem der Ansprüche 1 bis 5, **gekennzeichnet durch** eine Plasmareinigungseinrichtung zum Reinigen des fadenförmigen Gegenstandes vor dem Zuführen in die Behandlungskammer (9).

7. Verfahren zum Behandeln der Oberfläche von einem fadenförmigen Gegenstand (2), insbesondere von Fäden, die aus einem oder mehreren Filamenten aufgebaut sind, oder von Fasern für textile Gebilde, insbesondere mit einer Vorrichtung nach einem der Ansprüche 1 bis 6, mit den Schritten
Zuführen (5) des fadenförmigen Gegenstandes (2) in eine Behandlungskammer (9),
Durchlaufen des fadenförmigen Gegenstandes (2) durch die Behandlungskammer (9) über zwei Rollen (1), wobei Teilabschnitte des fadenförmigen Gegenstandes (2) zwischen den zwei Rollen (1) jeweils nebeneinander angeordnet sind, Behandeln des fadenförmigen Gegenstandes,
Ausführen (7) des fadenförmigen Gegenstandes aus der Behandlungskammer (9),
**dadurch gekennzeichnet, dass**
das Behandeln des fadenförmigen Gegenstandes (2) ein Plasmabeschichten umfasst,
die zumindest eine Fläche der nebeneinander angeordneten Teilstücke des fadenförmigen Gegenstandes (2) dadurch ausgebildet wird, dass die Rollen in einem ersten, Längenunterschiede der Teilabschnitte verursachenden Verschränkungswinkel von 0,5° bis 10°, vorzugsweise von 2° bis 3°, und zum Ausgleich der durch den besagten ersten Verschränkungswinkel verursachten Längenunterschiede der Teilabschnitte des fadenförmigen Gegenstandes um einen zweiten Verschränkungswinkel windschief zueinander angeordnet sind, wobei das Behandeln des fadenförmigen Gegenstandes (2) eine Beschichtung mit einer Schicht mit einer Schichtdicke von unter 1000 nm, insbesondere mit einer leitenden Schicht umfasst, wobei das Beschichten mit dem Plasma mittels zumindest einer in der Behandlungskammer angeordneten Plasmabeschichtungseinrichtung (3) zumindest auf die aussen liegenden Flächen zwischen den zwei Rollen (1) ausgeführt wird, und wobei das Beschichten mit dem Plasma der Plasmabeschichtungseinrichtung (3) ionisierte Teilchen umfasst, die mit einen Sputterprozess mittels zumindest einer Zerstäubungsquelle umfasst, wobei die schichtbildenden Teilchen aus zumindest einem Sputtertarget herausgelöst und auf der Oberfläche des fadenförmigen Gegenstandes (2) abgelagert werden.

8. Verfahren nach Anspruch 7, **dadurch gekennzeichnet, dass** auf dem fadenförmigen Gegenstand zusätzlich zur Plasmabeschichtung eine Abscheidung mittels einer Elektrode aus einer Gasphase erfolgt.

9. Verfahren nach einem der Ansprüche 7 oder 8, **dadurch gekennzeichnet, dass** zwischen einer Rolle der zwei Rollen (1) oder den Rollen (1) und der Behandlungskammer (9) ein elektrisches Spannungspotential oder eine Wechselspannung eingerichtet wird.

10. Verfahren nach einem der Ansprüche 7 bis 9, **dadurch gekennzeichnet, dass** der Prozess mit dem Messwert des elektrischen Widerstandes des fadenförmigen Gegenstandes (2) gesteuert oder geregelt wird.

**Claims**

1. Arrangement for treating the surface of a thread-like object (2), particularly the surface of threads that are composed of one or more filaments, and/or of fibers for textile structures, comprising
a treatment chamber (9) having at least one surface treatment device (3) for treating the surface of the thread-like object (2),
a device for transporting (4, 6) the thread-like object (2) through the treatment chamber (9),
a roller device (1, 10) arranged in the treatment chamber (9) and having two rollers (1) for spanning and continuous transporting partial sections of the thread-like object (2) each adjacent to each other,
a device (7) for guiding the thread-like object out of the treatment chamber (9),
**characterized in that**
the rollers (1) include a first crossing angle of 0,5° to 10°, preferably of 2° to 3°, which causes mutual length differences of the partial sections, and
the rollers are arranged skewed with respect to each other about a second crossing angle so as to compensate the length differences of the partial sections of the thread-like object (2) caused by said first crossing angle,
the surface treatment device (3) comprising a plasma coating device with a sputtering target for applying a layer with a layer thickness of less than 1000 nm, particularly with an electrically conductive layer.

2. The arrangement according to claim 1, further **characterized by** an electrode, particularly for carrying out a deposition process from the gas phase onto the thread-like object, wherein there is a contact between the electrode and the thread-like object or wherein the distance between the electrode and the thread-like object (2) is smaller than 2 cm.

3. The arrangement according to one of claims 1 or 2, **characterized by** at least one driving device (4) for the rollers, preferably a motor for each one of the rollers, for the purposes of transporting and guiding of the thread-like object (2).

4. The arrangement according to one of claims 1 to 3, **characterized in that** it comprises a further plasma coating device which is substantially parallel to the first plasma coating device (3), wherein the two plasma coating devices are each assigned to a facing region of the surface of the thread-like object (2) between the rollers (1).

5. The arrangement according to one of claims 1 to 4, **characterized by** means for establishing an electrical voltage potential or an alternating voltage between one roller of the two rollers (1), or the rollers (1), and the treatment chamber (9).

6. The arrangement according to one of claims 1 to 5, **characterized by** a plasma cleaning device for cleaning the thread-like object prior to being supplied into the treatment chamber (9).

7. A method for treating the surface of a thread-like object (2), particularly of threads that are composed of one or more filaments, or of fibers for textile structures, particularly by means of a device according to one of claims 1 to 6, comprising the steps of
supplying (5) the thread-like object (2) into a treatment chamber (9),
passing of the thread-like object (2) through the treatment chamber (9) via two rollers (1), wherein partial sections of the thread-like object (2) are arranged between the two rollers (1) each adjacent to each other,
subjecting the thread-like object to a treatment,
withdrawing (7) the thread-like object from the treatment chamber (9),
**characterized in that**
the treatment of the thread-like object (2) comprises a plasma coating,

the at least one surface of the partial sections of the thread-like object (2) arranged adjacent to each other is formed by virtue of the fact that the rollers are arranged in a first crossing angle of 0,5° to 10°, preferably of 2° to 3°, which causes mutual length differences of the partial sections, and skewed with respect to each other about a second crossing angle so as to compensate the length differences of the partial sections of the thread-like object caused by said first crossing angle, wherein the treatment of the thread-like object (2) comprises coating by applying a layer with a layer thickness of less than 1000 nm, particularly with an electrically conductive layer, wherein the coating with the plasma is carried out at least onto the outer surfaces between the two rollers (1) by means of at least one plasma coating device (3) arranged in the treatment chamber, and wherein the coating with the plasma of the plasma coating device (3) comprises ionized particles which are applied with a sputtering process by means of at least one sputtering source, wherein the layer-forming particles are released from at least one sputtering target and are deposited onto the surface of the thread-like object (2).

8. The method according to claim 7, **characterized in that** in addition to the plasma coating, a deposition process from the gas phase is carried out by means of an electrode onto the thread-like object.

9. The method according to one of claims 7 or 8, **characterized in that** between one roller of the two rollers (1), or the rollers (1), and the treatment chamber (9) an electrical voltage potential or an alternating voltage is established.

10. The method according to one of claims 7 to 9, **characterized in that** the process is controlled or regulated by means of the measured value of the electrical resistance of the thread-like object (2).

**Revendications**

1. Dispositif de traitement de la surface d'un objet filiforme (2), en particulier la surface de fibres qui sont constituées d'un ou de plusieurs filament(s) et/ou de fibres destinées à un produit textile, comprenant :

une chambre de traitement (9) comprenant au moins un dispositif de traitement de surfaces (3) permettant de traiter la surface de l'objet filiforme (2),
un dispositif de transport (4, 6) de l'objet filiforme (2) au travers de la chambre de traitement (9),
un dispositif à rouleaux (1, 10) situé dans la chambre de traitement (9) et comprenant deux rouleaux (1) permettant de tendre et de transporter de manière continue des segments partiels de l'objet filiforme (2) respectivement situés côte à côte,
un dispositif (7) permettant d'extraire l'objet filiforme de la chambre de traitement (9),
**caractérisé en ce que**
les rouleaux (1) ont l'un par rapport à l'autre, un premier angle d'imbrication de 0,5° à 10° de préférence de 2° à 3° provoquant des différences de longueur des segments partiels, et
pour permettre de compenser la différence de longueur des segments partiels de l'objet filiforme (2) provoquée par le premier angle d'imbrication, les rouleaux inclinés de travers l'un par rapport à l'autre d'un second angle d'imbrication,
le dispositif de traitement de surfaces (3) comprenant un dispositif de revêtement par plasma ayant une cible de pulvérisation permettant d'appliquer une couche en particulier une couche électriquement conductrice ayant une épaisseur inférieure à 1000 nm.

2. Dispositif conforme à la revendication 1, **caractérisé en outre par** une électrode, en particulier pour effectuer un dépôt à partir de la phase gazeuse sur l'objet filiforme, un contact étant établi entre l'électrode et l'objet filiforme, où la distance entre l'électrode et l'objet filiforme (2) étant inférieure à 2 cm.

3. Dispositif conforme à l'une des revendications 1 et 2, **caractérisé par** au moins un dispositif d'entraînement (4) des rouleaux, de préférence un moteur pour chacun des rouleaux de façon à permettre le transport et le guidage du produit filiforme (2).

4. Dispositif conforme à l'une des revendications 1 à 3, **caractérisé en ce qu'** il comporte un autre dispositif de revêtement par plasma essentiellement parallèle au premier dispositif de revêtement par plasma (3), les deux dispositifs de revêtement par plasma étant respectivement associés à une zone de la surface de l'objet filiforme (2) tournée vers eux située entre les rouleaux (1).

5. Dispositif conforme à l'une des revendications 1 à 4, **caractérisé par** des moyens permettant d'appliquer un potentiel de tension électrique ou une tension alternative entre l'un des deux rouleaux (1) ou les rouleaux (1) et la chambre de traitement (9).

6. Dispositif conforme à l'une des revendications 1 à 5, **caractérisé par** un dispositif de nettoyage par plasma permettant de nettoyer l'objet filiforme avant son introduction dans la chambre de traitement (9).

**7.** Procédé de traitement de la surface d'un objet filiforme (2), en particulier de fibres qui sont constituées d'un ou de plusieurs filament(s) ou de fibres destinées à des produits textiles, en particulier avec un dispositif conforme à l'une des revendications 1 à 6, comportant des étapes consistant à :

introduire (5) l'objet filiforme (2) dans une chambre de traitement (9),
faire passer l'objet filiforme (2) au travers de la chambre de traitement (9) par l'intermédiaire de deux rouleaux (1), des segments partiels de l'objet filiforme (2) étant respectivement situés côte à côte entre les deux rouleaux (1),
traiter l'objet filiforme,
extraire (7) l'objet filiforme de la chambre de traitement (9),
**caractérisé en ce que**
le traitement de l'objet filiforme (2) comporte un revêtement par plasma, la surface des segments partiels de l'objet filiforme (2) situés côte à côte est formée de sorte que les rouleaux soient positionnés l'un par rapport à l'autre, selon un premier angle d'imbrication de 0,5° à 10° de préférence de 2° à 3° provoquant des différences de longueur des segments partiels, et pour compenser les différences de longueur des segments partiels de l'objet filiforme provoquées par le premier angle d'imbrication soient inclinés de travers l'un par rapport à l'autre, d'un second angle d'imbrication, le traitement de l'objet filiforme (2) comprenant un revêtement avec une couche en particulier avec une couche conductrice, ayant une épaisseur inférieure à 1000 nm, le revêtement avec le plasma étant mis en oeuvre au moyen d'au moins un dispositif de revêtement par plasma (3) monté dans la chambre de traitement, au moins sur les surfaces situées vers l'extérieur entre les deux rouleaux (1), et le revêtement avec le plasma du dispositif de revêtement par plasma (3) comprenant des particules ionisées obtenues par un processus de pulvérisation au moyen d'au moins une source de vaporisation, les particules formant la couche étant extraites d'au moins une cible de pulvérisation et déposées sur la surface de l'objet filiforme (2).

**8.** Procédé conforme à la revendication 7,
**caractérisé en ce que**
l'on effectue sur l'objet filiforme en plus du revêtement par plasma, un dépôt au moyen d'une électrode à partir d'une phase gazeuse.

**9.** Procédé conforme à l'une des revendications 7 à 8,
**caractérisé en ce que**

l'on établit un potentiel électrique ou une tension alternative entre l'un des rouleaux parmi les deux rouleaux (1) ou les rouleaux (1) et la chambre de traitement (9).

**10.** Procédé conforme à l'une des revendications 7 à 9,
**caractérisé en ce que**
le processus est commandé ou régulé avec la valeur de mesure de la résistance électrique de l'objet filiforme (2).

**Figur 1**

**Figur 2**

**Figur 3**

**Figur 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4042737 A
- DD 252009 A1
- EP 0695384 B1
- JP 2005113165 A
- US 5972160 A
- WO 92014860 A
- WO 97036021 A
- DE 4105896 A1
- US 3379803 A
- DE 19612225 A1
- JP 2000314039 A
- JP A1 A
- WO 9308320 A

**In der Beschreibung aufgeführte Nicht-Patentliteratur**

- Smart textiles for medicine and healthcare. 2007
- **M. AMBERG ; J. GEERCK ; M. KELLER ; A. FISCHER.** *Plasma Devices and Operations,* 2004, vol. 12, 175-186